Europäisches Patentamt

European Patent Office

Office européen des brevets

(11) Veröffentlichungsnummer: **0 680 143 A2**

## (12) EUROPÄISCHE PATENTANMELDUNG

(21) Anmeldenummer: **95104588.9**

(22) Anmeldetag: **28.03.95**

(51) Int. Cl.6: **H03H 11/28**, H03H 11/24

(30) Priorität: **07.04.94 DE 4412055**

(43) Veröffentlichungstag der Anmeldung:
**02.11.95 Patentblatt 95/44**

(84) Benannte Vertragsstaaten:
**AT BE CH DE FR GB IT LI NL SE**

(71) Anmelder: **SIEMENS AKTIENGESELLSCHAFT**
**Wittelsbacherplatz 2**
**D-80333 München (DE)**

(72) Erfinder: **König, Wilhelm, Dipl.-Ing.**
**Falkenstrasse 43**
**D-86391 Stadtbergen (DE)**

(54) **CMOS-Abschlusswiderstandsschaltung.**

(57) Der Abschlußwiderstand ist durch ein CMOS-Transmission-Gate gebildet, das mit seinen Steuerelektroden an die Steuerelektroden eines internen Referenz-Transmission-Gates angeschlossen ist, dessen eine Steuerelektrode mit dem Ausgang eines als Differenzverstärker geschalteten ersten Operationsverstärkers verbunden ist, dessen andere Steuerelektrode mit dem Ausgang eines über seinen invertierenden Eingang dem Differenzverstärker nachgeschalteten, als invertierender Verstärker geschalteten zweiten Operationsverstärkers verbunden ist und das zusammen mit einem Stromspiegeltransistor einer von einer Referenzstromquelle her gespeisten Stromspiegelschaltung eine Serienschaltung bildet, die parallel zu einer von einem externen Referenzwiderstand mit dem gewünschten Abschlußwiderstandswert entsprechendem Widerstandswert und einem weiteren Stromspiegeltransistor gebildeten weiteren Serienschaltung an einer Abschlußspannungsquelle liegt, wobei die beiden Eingänge des Differenzverstärkers mit den Verbindungspunkten der beiden Serienschaltungen verbunden sind.

FIG 1

EP 0 680 143 A2

In nachrichtentechnischen Systemen und bei Computern müssen zur Übertragung von sehr hohen Datenraten zwischen integrierten Bausteinen Leitungen mit definiertem Wellenwiderstand verwendet werden und am Leitungsende mit einem Widerstand abgeschlossen werden, der dem Wellenwiderstand der Leitung entspricht. Andernfalls treten Reflexionen und damit Störungen auf, die sich dem Nutzsignal überlagern und am Empfänger zu Bitfehlern führen können.

Datenraten im Bereich von ca. 100 MBit/s bis 1 GBit/s waren bei integrierten Schaltungen früher Bipolar- oder Galliumarsenid-Bausteinen vorbehalten; durch Fortschritte in der Halbleitertechnologie haben inzwischen auch CMOS-Bausteine diesen Geschwindigkeitsbereich erreicht. Bei der Übertragung so hoher Datenraten sind deshalb auch an den Eingängen von CMOS-Bausteinen Abschlußwiderstände erforderlich.

Bislang werden bei CMOS-Bausteinen die Abschlußwiderstände außerhalb des Bausteins auf der Leiterplatte dicht an den entsprechenden Eingangspins angeordnet. Bausteine von Vermittlungssystemen, z.B. Koppelfeldbausteine, oder von Computern, z.B. Speicher mit Adreß- und Datenleitungen, können eine größe Anzahl von Eingängen haben, so daß für die zugehörigen Abschlußwiderstände ein wesentlicher Platzbedarf entsteht, der die Pakkungsdichte auf der Baugruppe reduziert. Bei hohen Frequenzen ist folgender Umstand von weiterem Nachteil: Der Abschluß erfolgt nicht unmittelbar an der Eingangsstufe des Empfängerbausteins; vielmehr befinden sich zwischen Abschlußwiderstand und Eingangsstufe noch das Gehäuse des Bausteins und die Schutzstrukturen gegen elektrostatische Aufladung, die bei CMOS-Bausteinen notwendig sind. Elektrisch gesehen besteht das Gehäuse im Wesentlichen aus Leitungsinduktivitäten und -kapazitäten wie Pin- und Bond-Induktivitäten und parasitären Lastkapazitäten; dazu kommen noch Koppelinduktivitäten und -kapazitäten zwischen den Pins. Der Weg vom externen Abschlußwiderstand zur Eingangsstufe kann als nichtabgeschlossene Leitung betrachtet werden, die zu Reflexionen führt, auf Grund derer die Übertragung hoher Frequenzen schwierig wird.

Abschlußwiderstände bei IC-Bausteinen sind zum Beispiel aus Safferthal: "Terminieren von Signalleitungen", Elektronik 22/1990, Seiten 236 ... 254, bekannt.

Auf Grund der beschriebenen Nachteile wäre es wünschenswert, die Leitung auf dem Chip direkt an der Eingangsstufe abzuschließen. Bei gängigen CMOS-Technologien steht aber keine ausreichend genaue Widerstandsschicht zur Verfügung; Polysilizium- oder Metallbahnen und Wannenwiderstände haben zu große Fertigungstoleranzen und große Temperaturkoeffizienten, die zu Gesamtvariationen im Widerstandswert von ± 50 % führen können. Bei solchen Variationen entstehen unerwünschte Reflexionen und - wenn der Sender als Stromquelle arbeitet, was in der Praxis oft der Fall ist - große Schwankungen in den Eingangspegeln.

Ein Präzisionswiderstand in MOS-Technologie ist zusammen mit der zugehörigen Ansteuerschaltung z.B. aus GB-A-2 248 143 bekannt.

Die vorliegende Erfindung stellt sich nun die Aufgabe, die Realisierung eines genauen Abschlußwiderstands in CMOS-Technologie anzugeben.

Die Erfindung betrifft eine CMOS-Abschlußschaltung; diese Abschlußschaltung ist erfindungsgemäß dadurch gekennzeichnet, daß der Abschlußwiderstand durch ein CMOS-Transmission-Gate gebildet ist, das mit seinen Steuerelektroden an die Steuerelektroden eines integrierten Referenz-Transmission-Gates angeschlossen ist,

dessen eine Steuerelektrode mit dem Ausgang eines als Differenzverstärker geschalteten ersten Operationsverstärkers verbunden ist,

dessen andere Steuerelektrode mit dem Ausgang eines über seinen invertierenden Eingang dem Differenzverstärker nachgeschalteten, als invertierender Verstärker (mit zweckmäßigerweise gleichen Widerstandswerten des Vorwiderstands und des Rückkopplungswiderstands) geschalteten zweiten Operationsverstärkers verbunden ist

und das zusammen mit einem Stromspiegel-Transistor einer von einer Referenzstromquelle her gespeisten Stromspiegelschaltung eine Serienschaltung bildet, die parallel zu einer von einem externen Referenzwiderstand (mit dem gewünschten Abschlußwiderstandswert entsprechendem Widerstandswert) und einem weiteren Stromspiegel-Transistor gebildeten weiteren Serienschaltung an einer Abschlußpotentialquelle liegt,

wobei die beiden Eingänge des Differenzverstärkers mit den beiden inneren Verbindungspunkten der beiden Serienschaltungen verbunden sind;

die Transistoren der Stromspiegelschaltung können dabei zweckmäßigerweise jeweils gleiche Kanallängen bzw. -weiten haben.

Die Erfindung bringt den Vorteil mit sich, genaue interne Abschlußwiderstände in CMOS-Technologie zu ermöglichen und damit auf externe Abschlußwiderstände verzichten zu können, den Platzbedarf zu reduzieren und eine höhere Integration auf der Baugruppe zu erreichen; zugleich wird das Hochfrequenzverhalten verbessert, so daß höhere Bitraten möglich sind.

In Weiterbildung der Erfindung kann auch dem in Serie zum externen Referenzwiderstand liegenden Stromspiegel-Transistor der mit einer Referenzspannungsquelle versehene Eingangskreis eines Komparators parallelgeschaltet sein, dessen Ausgang direkt bzw. über einen Inverter zu den Steuereingängen zweier CMOS-Transistoren entgegengesetzten Kanaltyps führen, deren einer mit seinen Hauptelektroden zwischen Masse und der Ausgangsleitung des einen Differenzverstärkers liegt und deren anderer mit seinen Hauptelektroden zwischen der Versorgungspotentialquelle und der Ausgangsleitung des anderen Differenzverstärkers liegt. vorgesehen sein; dies ermöglicht es, flexibel zwischen internem oder externem Abschluß zu wechseln, was die Signalverteilung an mehrere Bausteine erleichtern kann.

Weitere Besonderheiten der Erfindung werden aus der nachstehenden Beschreibung an Hand der Zeichnungen ersichtlich. Dabei zeigen

Figur 1   ein Ausführungsbeispiel einer CMOS-Abschlußwiderstandsschaltung gemäß der Erfindung und

Figur 2   ein weiteres Ausführungsbeispiel einer solchen CMOS-Abschlußwiderstandsschaltung;

Figur 3   zeigt dazu ein Anwendungsbeispiel.

Figur 4   zeigt eine Weiterbildung einer CMOS-Abschluß-Widerstandsschaltung gemäß der Erfindung, und

Figur 5   zeigt ein Anwendungsbeispiel dazu.

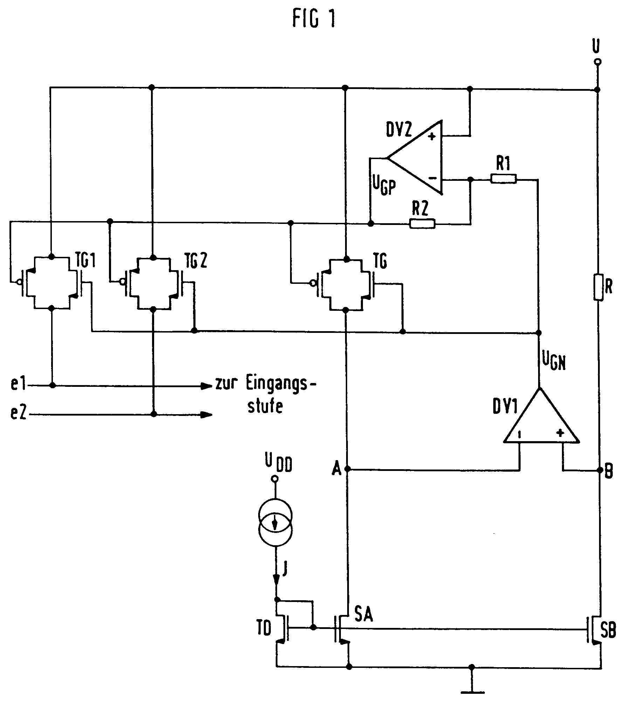

In der in Fig.1 skizzierten CMOS-Abschlußwiderstandsschaltung ist der Abschlußwiderstand erfindungsgemäß mit einem sog. Transmission-Gate realisiert. Ein Transmission-Gate besteht im Prinzip aus einem p-Kanal-Transistor und einem ihm parallelgeschalteten n-Kanal-Transistor. Die Verwendung eines Transmission-Gates als Widerstand ist in der CMOS-Technik an sich bekannt. Die Transistoren werden dabei im Widerstandsbereich ihrer Kennlinien betrieben, d.h. es wird der Umstand ausgenutzt, daß für genügend kleine Drain-Source-Spannungen ein MOS-Transistor sich zwischen Drain- und Source-Anschluß wie ein linearer ohmscher Widerstand verhält. Der Widerstandswert hängt dabei von der Gate-Source-Spannung ab und kann damit eingestellt werden. Um nun das Transmission-Gate TG (in Fig.1) auf einen definierten Widerstand von z.B. 50 Ω einzustellen, wird ein externer Widerstand R (außerhalb des Bausteins) als Referenzelement verwendet, dessen Widerstandswert dem gewünschten Abschlußwiderstandswert entspricht. Das Transmission-Gate TG bildet zusammen mit einem Stromspiegel-Transistor SA einer von einer Referenzstromquelle J her gespeisten Stromspiegelschaltung TD, SA, SB eine Serienschaltung TG-SA, die parallel zu einer von dem externen Referenzwiderstand R und einem weiteren Stromspiegel-Transistor SB gebildeten weiteren Serienschaltung R-SB an einer mit ihrer Spannung dem gewünschten Abschlußpotential entsprechenden Abschlußpotentialquelle U liegt. Die eine Steuerelektrode des Transmission-Gates TG ist mit dem Ausgang eines als Differenzverstärker geschalteten ersten Operationsverstärkers DV1 verbunden; seine andere Steuerelektrode ist mit dem Ausgang eines über seinen invertierenden Eingang dem Differenzverstärker DV1 nachgeschalteten, als invertierender Verstärker geschalteten zweiten Operationsverstärkers verbunden. Dessen Vorwiderstand R1 und Rückkopplungswiderstand R2 haben zweckmäßigerweise gleiche Widerstandswerte, so daß die Verstärkung gleich 1 ist. Die beiden Eingänge des Differenzverstärkers DV1 sind, wie dies auch aus Fig.1 ersichtlich ist, mit den beiden inneren Verbindungspunkten A, B der beiden Serienschaltungen TG-SA, R-SB verbunden, d.h. mit dem Verbindungspunkt A zwischen Transmission-Gate TG und Stromspiegel-Transistor SA bzw. mit dem Verbindungspunkt B zwischen Referenzwiderstand R und Stromspiegel-Transistor SB. Die Transistoren TD, SA, SB der Stromspiegelschaltung haben zweckmäßigerweise jeweils gleiche Kanallängen bzw. -weiten; dann ist der durch die Stromspiegel-Transistoren SA, SB fliessende Strom jeweils gerade so groß wie der durch den Dioden-Transistor TD fliessende Strom, d.h. es wird der Referenzstrom J vom Dioden-Transistor TD auf die Stromspiegel-Transistoren SA und SB gespiegelt. Die Erzeugung eines Referenzstromes ist aus der Literatur (z.B. Paul R. Gray, Robert G. Meyer, "Analysis and Design of Analog Integrated Circuits", John Wiley & Sons, New York, 1984) vielfach bekannt und braucht hier nicht weiter erläutert zu werden.

Wenn durch die Stromspiegel-Transistoren SA und SB gleiche Ströme fliessen, fliessen auch durch den externen Referenzwiderstand R und das interne Transmission-Gate TG gleiche Ströme. Der Differenzverstärker DV1 vergleicht die Spannungen an den Punkten A und B und erzeugt eine Ausgangsspannung $U_{GN}$, die über den entsprechenden Steuereingang des Transmission-Gates TG den Widerstand des n-Kanal-Transistors im Transmission-Gate steuert. In entsprechender Weise steuert der invertierende Verstärker DV2 mit seiner Ausgangsspannung $U_{GP}$ den Widerstand des p-Kanal-Transistors im Transmission-Gate. Die Widerstände R1 und R2 des invertierenden Verstärkers DV2 können in CMOS-Technik als Wannenwiderstände realisiert sein, da es zur Verstärkungseinstellung nur auf das Verhältnis der Widerstandswerte ankommt, nicht aber auf die absoluten Werte. Am Ausgang des invertierenden Verstärkers DV2 entsteht als Ausgangsspannung die Differenzspannung $U_{GP} = 2 \cdot U - U_{GN}$. Bezogen auf die Abschlußspannung U liegen also am p-Kanal-Transistor und am n-Kanal-Transistor des Transmission-Gates TG im Betrag gleich große Gate-Source-Spannungen mit umgekehrten Vorzeichen an; beide Transistoren werden somit gleichsinnig mehr oder weniger leitend. Ist in der Schaltungsanordnung nach Fig.1 das Potential am Schaltungspunkt B positiver als am Schaltungspunkt A, so bedeutet dies, daß der Widerstandswert des Transmission-Gates TG größer ist als derjenige des Referenzwiderstands R, da ja durch beide gleiche Ströme fließen. Dies hat zur Folge, daß die Steuerspannung $U_{GN}$ ansteigt und die Steuerspannung $U_{GP}$ absinkt, so daß das Transmission-Gate TG weiter aufgesteuert und damit sein Widerstand verkleinert wird, und zwar so lange, bis die Widerstandswerte von Transmission-Gate TG und Referenzwiderstand R gleich sind und die Schaltungspunkte A und B auf gleichem Potential liegen.

Auf diese Weise wird der Widerstandswert des internen, d.h. integrierten Transmission-Gates TG automatisch auf den Wert des externen Widerstands R geregelt. Die Regelspannungen $U_{GN}$ und $U_{GP}$ können dann zur Steuerung des eigentlichen Abschlußwiderstands verwendet werden. In Fig.1 ist als Beispiel ein differentieller Eingang mit zwei Transmission-Gates TG1 und TG2 als Abschluß zweier Eingangsklemmen e1, e2 dargestellt. Die Transmission-Gates TG1 und TG2 werden ebenso wie das Transmission-Gate TG dimensioniert und nahe diesem plaziert, so daß sie insoweit identisch mit dem Transmission-Gate TG sind und an ihnen durch die Regelspannungen $U_{GN}$ und $U_{GP}$ der gleiche Widerstandswert eingestellt wird.

Um Verlustleistung zu sparen, kann der Widerstandswert des externen Widerstands R vergrößert werden, während die Größe des hindurchfließenden Stromes entsprechend verringert wird. Hat der Widerstand R beispielsweise den 10fachen Wert des gewünschten Abschlußwiderstands, dann muß der Wert des durch den Stromspiegel-Transistor SB fliessenden Stroms ein Zehntel des Wertes des Referenzstroms J betragen, um an den Verbindungspunkten A und B wieder gleiches Potential zu erhalten. Dies ist am Stromspiegel leicht realisierbar, indem die Weite des Stromspiegel-Transistors SB auf ein Zehntel der Weite des Stromspiegel-Transistors SA dimensioniert wird.

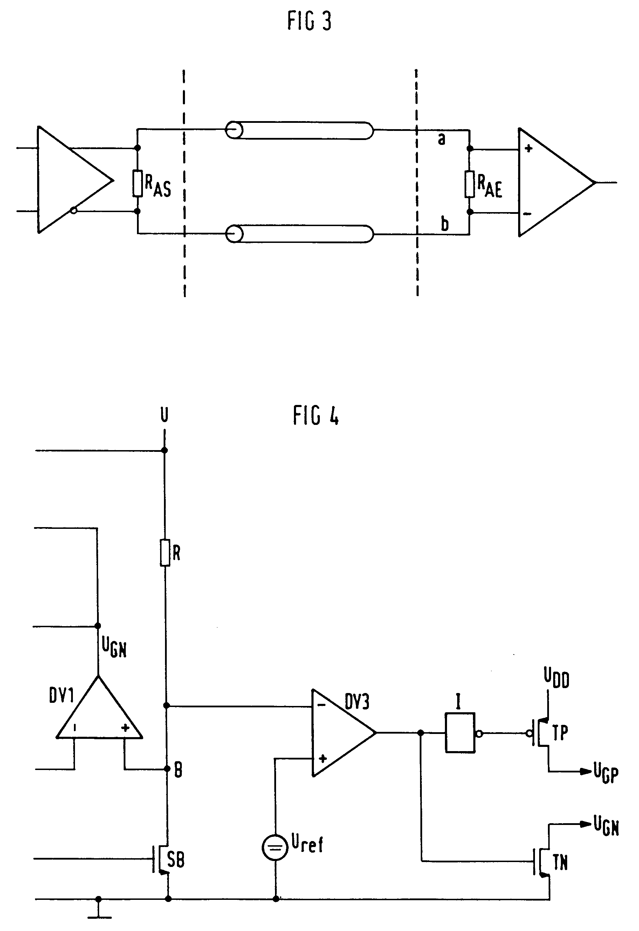

Für bestimmte Anwendungen mit differentieller Signalübertragung ist es erforderlich, Eingangsklemmen nicht jeweils für sich gegen ein Abschlußpotential U abzuschließen, sondern einen Abschlußwiderstand zwischen den beiden Eingangsklemmen vorzusehen. Dies kann beispielsweise bei einem (von IEEE standardisierten) sog. SCI-LVDS-Interface (Draft Standard for SCI LVDS, Low Voltage differential Signals, IEEE-Standard P1596.3 vom 9.9.1993) der Fall sein, wie es in Fig.3 skizziert ist: Die Übertragung erfolgt differentiell, der Empfängereingang wird mit einem Widerstand $R_{AE}$ zwischen den Signalleitungsadern a, b abgeschlossen, wobei der Wert des Abschlußwiderstands den doppelten Wert des Wellenwiderstands der Signalleitung haben muß.

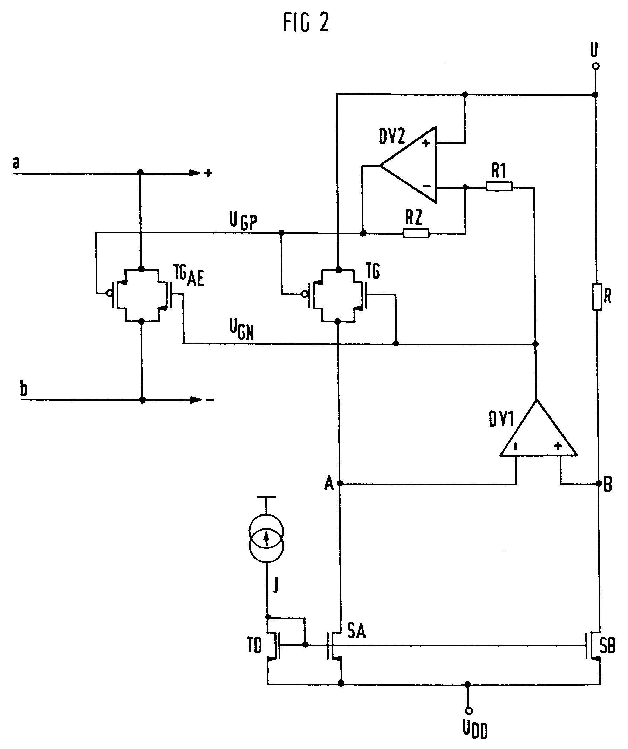

Ein solcher schwebender Abschlußwiderstand ($R_{AE}$ in Fig.3) kann wiederum mittels eines Transmission-Gates ($TG_{AE}$ in der im übrigen weiter unten erläuterten Fig.2) realisiert werden, das in der an Hand von Fig.1 erläuterten Weise von den Ausgangsspannungen $U_{GN}$ und $U_{GP}$ eines Differenzverstärkers DV1 und eines ihm nachgeschalteten invertierenden Verstärkers DV2 gesteuert wird, wobei der Differenzverstärker DV1 mit seiner einen Eingangsklemme am Verbindungspunkt der Serienschaltung eines Referenz-Transmission-Gates TG und eines Stromspiegel-Transistors SA und mit seiner anderen Eingangsklemme am Verbindungspunkt der Serienschaltung eines Referenzwiderstands R und eines Stromspiegel-Transistors SB liegt.

Eine optimale Einstellung auf den Referenzwiderstand R wird erreicht, wenn die an den Serienschaltungen TG-SA, R-SB liegende Spannung U etwa in die Mitte zwischen dem High- und dem Low-Pegel des Eingangssignals gelegt wird. Wenn der Gleichstromanteil des Eingangssignals unbekannt ist oder sich ändern kann, wird die Spannung U zweckmäßig gleich der halben Versorgungsspannung gewählt. Je weiter der Gleichtaktanteil des Eingangssignals vom Wert U weg liegt, desto mehr kann sich dann der Widerstandswert des am abzuschliessenden Eingang liegenden Transmission-Gates von demjenigen des Referenzwiderstands R unterscheiden. Dabei entsteht indessen ein Kompensationseffekt: Nähert sich z.B. der Gleichtaktanteil dem Massepotential (Ground), dann steigt der Widerstand des p-Kanal-Transistors des Transmission-Gates. Gleichzeitig steigt aber die Gate-Source-Spannung des n-Kanal-Transistors an, und demzufolge sinkt der Widerstand des n-Kanal-Transistors. Auf diese Weise wird die Zunahme des Widerstands des p-Kanal-Transistors zum großen Teil kompensiert. Nähert sich der Gleichtaktanteil der Versorgungsspannung $U_{DD}$, so tritt derselbe Kompensationseffekt am p-Kanal-Transistor auf.

Simulationen haben gezeigt, daß in einer heutigen $0.5\mu$ CMOS-Technologie mit 3.3 V Versorgungsspannung eine gute Kompensation erreicht wird, wenn die Spannung U etwa bei der halben Versorgungsspannung liegt. Der Gleichtaktanteil am Eingang kann sich dann praktisch im ganzen Bereich der Versorgungsspannung bewegen, wobei durch den beschriebenen Kompensationseffekt auch an den Bereichsgrenzen noch ein akzeptabler Abschluß erreicht wird.

Bei dem erwähnten SCI-LVDS-Interface ist zwischen den Signalpegeln High und Low ein Mittenpegel von 1,2 V (bezogen auf das Massepotential des Senders) definiert; insofern wäre eine Abschlußspannung U von 1,2 V wünschenswert. Da dann der Arbeitsbereich für die Schaltung nach Fig.1 jedoch etwas knapp sein mag, kann die Abschlußspannung U gleich der halben Versorgungsspannung gewählt werden, wie oben bereits beschrieben wurde. Gegebenenfalls ist es jedoch vorteilhafter, dann den Stromspiegel mit p-Kanal-Transistoren statt mit n-Kanal-Transistoren zu realisieren und an die Speisepotentialquelle $U_{DD}$ anzubinden; die Referenzstromquelle ist dann umzudrehen. Die Spannungen sind dann auf $U_{DD}$ bezogen, und es steht daher ein größerer Spannungsbereich für die Regelschaltung zur Verfügung. Eine solche CMOS-Abschlußwiderstandsschaltung für einen schwebenden Abschlußwiderstand $TG_{AE}$ ist in Fig.2 skizziert. Die Funktion dieser Abschlußwiderstandsschaltung im übrigen ist im Prinzip gleich derjenigen der Abschlußwiderstandsschaltung gemäß Fig.1, so daß es hier keiner weiteren Erläuterungen mehr bedarf.

Die Spezifikation des in Fig.3 skizzierten SCI-LVDS-Interface fordert auch für den Ausgang des Sendebausteins einen bestimmten Innenwiderstand, damit auch bei eventuell durch Unsymmetrien oder Störungen auftretenden rücklaufenden Wellen am Ausgang keine Reflexionen entstehen. Arbeitet dabei die Ausgangsstufe des Senders als Stromquelle, die einen eingeprägten Strom auf die Leitung schickt, so ist der Ausgang hochohmig, und es muß auch zwischen den Ausgangsleitungen ein Abschlußwiderstend $R_{AS}$ integriert werden. Auch dafür kann vorteilhaft das an Hand von Fig.2 beschriebene geregelte Transmission-Gate eingesetzt werden.

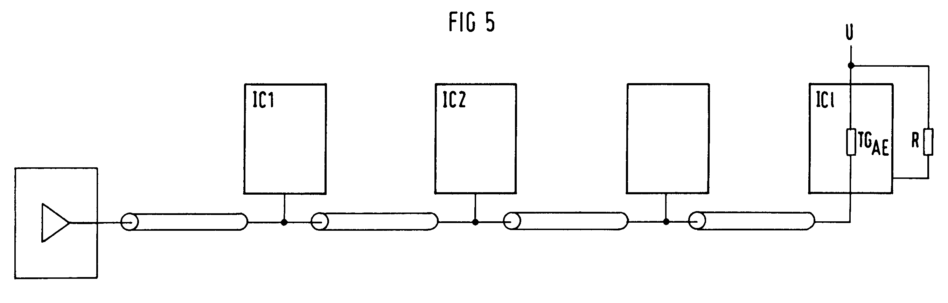

Insbesondere bei Vermittlungssystemen sind in deren Koppelfeldern oftmals Signale oder Takte von einem Sendebaustein nicht nur zu einem einzigen CMOS-Empfangsbaustein zu übertragen, sondern zu einer ganzen Reihe von CMOS-Empfangsbausteinen, die dazu an einunddieselbe, das Signal bzw. den Takt führende Leitung angeschlossen sind, wobei die Leitung erst am letzten Baustein mit einem Abschlußwiderstand abgeschlossen wird. Eine solche Konfiguration ist schematisch in Fig.5 skizziert; die CMOS-Bausteine sind hier mit IC1, IC2,..., ICl bezeichnet. Der Leitungsabschluß am letzten Baustein ICl kann dabei mittels einer CMOS-Abschlußwiderstandsschaltung gemäß der Erfindung bewirkt werden, während die Eingänge der übrigen Bausteine hochohmig sein müssen.

Um nun wahlweise am Bausteineingang entweder einen definierten Abschlußwiderstand oder aber einen Leerlaufwiderstand wirksam sein lassen und damit einheitliche CMOS-Bausteine verwenden zu können, kann nun, wie dies in Fig.4 skizziert ist, in weiterer Ausgestaltung der Erfindung in den einzelnen Abschlußwiderstandsschaltungen dem in Serie zum externen Referenzwiderstand R liegenden Stromspiegel-Transistor SB der mit einer Referenzspannungsquelle $U_{ref}$ versehene Eingangskreis eines Komparators DV3 parallelgeschaltet sein, dessen Ausgang direkt bzw. über einen Inverter I zu den Steuereingängen zweier MOS-Transistoren entgegengesetzten Kanaltyps führen, deren einer mit seinen Hauptelektroden zwischen Masse und der Ausgangsleitung des einen Differenzverstärkers DV1 liegt und deren anderer mit seinen Hauptelektroden zwischen der Versorgungspotentialquelle $U_{DD}$ und der Ausgangsleitung des anderen Differenzverstärkers DV2 liegt. In Fig.4 sind links noch der externe Widerstand R, der Stromspiegel-Transistor SB und der erste Differenzverstärker DV1 der übrigen Abschlußwiderstandsschaltung dargestellt, wie sie insoweit im Beispiel in Fig.1 in weiteren schaltungstechnischen Einzelheiten dargestellt ist. Als Komparator DV3 ist gemäß Fig.4 ein zusätzlicher Differenzverstärker vorgesehen, dessen nichtinvertierender Eingang mit der Referenzspannungsquelle $U_{ref}$ verbunden ist. Die Referenzspannung muß kleiner sein als die Spannung im Regelungsbetrieb am Knoten B auftretende Spannung. Dann befindet sich der Ausgang des Komparators im Low-Zustand, also in der Nähe des Massepotentials, und der direkt nachfolgende n-Kanal-Transistor TN und der über den Inverter I nachfolgende p-Kanal-Transistor TP sind nichtleitend und nehmen somit über die Steuerspannungsleitungen $U_{GN}$,$U_{GP}$ (in Fig. 4 und Fig.1) keinen Einfluß auf die Regelung des Abschlußwiderstandswertes. Die Referenzspannung läßt sich beispielsweise aus der Versorgungsspannung durch Spannungsteilung mit Hilfe von Wannenwiderständen ableiten, ohne daß dies hier noch weiterer Erläuterungen bedarf.

Läßt man nun in Abweichung von der Darstellung in Fig.4 den externen Referenzwiderstand R weg (R → ∞), dann zieht der Stromspiegel-Transistor SB den Knoten B auf Massepotential, der Ausgang des Komparators DV3 geht in den High-Zustand, und die beiden Transistoren TN und TP schalten durch. Die beiden Transistoren TN und TP sollen auf Grund der Dimensionierung stärker sein als die Ausgangstransistoren der beiden Differenzverstärker DV1 und DV2. Damit gelangt die Ausgangsleitung $U_{GN}$ auf das Massepotential und die Ausgangsleitung $U_{GP}$ auf das Speisepotential $U_{DD}$ mit der Folge, daß die Transmission-Gates (TG in der Regelschaltung und TG1, TG2 (bzw. $TG_{AE}$) an den Eingängen) hohe Widerstandswerte annehmen; die internen Abschlußwiderstände sind damit abgeschaltet.

Im Anwendungsbeispiel gemäß Fig.5 läßt man somit bei allen CMOS-Bausteinen IC1, ..., mit Ausnahme des letzten, den externen Referenzwiderstand (R in Fig.4) weg, und nur nur beim letzten CMOS-Baustein ICl sieht man diesen externen Referenzwiderstand vor mit dem Ergebnis, daß die zu den CMOS-Bausteinen IC1, ..., ICl führende Leitung gerade an ihrem Ende durch den CMOS-Baustein

ICI ordnungsgemäß abgeschlossen ist.

**Patentansprüche**

1. CMOS-Abschlußwiderstandsschaltung
**dadurch gekennzeichnet,**
daß der Abschlußwiderstand durch ein CMOS-Transmission-Gate (TG1, TG2; $TG_{AE}$) gebildet ist, das mit seinen Steuerelektroden an die Steuerelektroden eines internen Referenz-Transmission-Gates (TG) angeschlossen ist, dessen eine Steuerelektrode mit dem Ausgang eines als Differenzverstärker geschalteten ersten Operationsverstärkers (DV1) verbunden ist,
dessen andere Steuerelektrode mit dem Ausgang eines über seinen invertierenden Eingang dem Differenzverstärker (DV1) nachgeschalteten, als invertierender Verstärker geschalteten zweiten Operationsverstärkers (DV2) verbunden ist
und das zusammen mit einem Stromspiegel-Transistor (SA) einer von einer Referenzstromquelle (J) her gespeisten Stromspiegelschaltung (TD, SA, SB) eine Serienschaltung (TG-SA) bildet, die parallel zu einer von einem externen Referenzwiderstand (R) mit dem gewünschten Abschlußwiderstandswert entsprechendem Widerstandswert und einem weiteren Stromspiegel-Transistor (SB) gebildeten weiteren Serienschaltung (R-SB) an einer Abschlußspannungsquelle (U) liegt,
wobei die beiden Eingänge des Differenzverstärkers (DV1) mit den Verbindungspunkten (A; B) der beiden Serienschaltungen (TG-SA; R-SB) verbunden sind.

2. Abschlußwiderstandsschaltung nach Anspruch 1,
**gekennzeichnet durch**
einen dem gewünschten Abschlußwiderstandswert gleichen Widerstandswert des externen Referenzwiderstands (R).

3. Abschlußwiderstandsschaltung nach Anspruch 1 oder 2,
**gekennzeichnet durch**
jeweils gleiche Kanallängen bzw. Weiten der Transistoren (TD, SA, SB) der Stromspiegelschaltung.

4. Abschlußwiderstandsschaltung nach Anspruch 1 oder 2,
**dadurch gekennzeichnet,**
daß einer der Transistoren (SB) der Stromspiegelschaltung (TD, SA, SB) eine andere Kanalweite bzw. -länge als die anderen Transistoren (TD, SA) aufweist.

5. Abschlußwiderstandsschaltung nach einem der Ansprüche 1 bis 4,
**gekennzeichnet durch**
gleiche Widerstandswerte des Vorwiderstands (R1) und des Rückkopplungswiderstands (R2) des invertierenden Verstärkers (DV2).

6. Abschlußwiderstandsschaltung nach einem der Ansprüche 1 bis 5,
**dadurch gekennzeichnet,**
daß dem in Serie zum externen Referenzwiderstand (R) liegenden Stromspiegel-Transistor (SB) der mit einer Referenzspannungsquelle ($U_{ref}$) versehene Eingangskreis eines Komparators (DV3) parallelgeschaltet ist, dessen Ausgang direkt bzw. über einen Inverter (I) zu den Steuereingängen zweier CMOS-Transistoren (TN, TP) entgegengesetzten Kanaltyps führen, deren einer (TN) mit seinen Hauptelektroden zwischen Masse und der Ausgangsleitung ($U_{GN}$) des einen Differenzverstärkers (DV1) liegt und deren anderer (TP) mit seinen Hauptelektroden zwischen der Versorgungspotentialquelle ($U_{DD}$) und der Ausgangsleitung ($U_{GP}$) des anderen Differenzverstärkers (DV2) liegt.

FIG 1

FIG 2

# FIG 3

# FIG 4

FIG 5

U

R

TG AE

IC1

IC2

IC1